# EUROPÄISCHE PATENTSCHRIFT

(11) **EP 2 120 001 B1**
(45) Veröffentlichungstag und Bekanntmachung des Hinweises auf die Patenterteilung: **04.07.2012**
(21) Anmeldenummer: 09006321.5
(22) Anmeldetag: 11.05.2009
(51) Int. Cl.: F41H 5/22

(54) **Panzerfahrzeug mit einer mittels einer Luke veschliessbaren Fahrzeugöffnung**
Armoured vehicle with a manhole which is closable by a cover
Véhicule blindé avec trou d'homme fermable par un couvercle

(30) Priorität: 13.05.2008 DE 102008023273
(43) Veröffentlichungstag der Anmeldung: 18.11.2009
(73) Patentinhaber: Krauss-Maffei Wegmann GmbH & Co. KG, 80997 München (DE)
(72) Erfinder: Föhst, Stefan, 34376 Immenhausen (DE); Zenker, Klaus, 34260 Kaufungen (DE)
(74) Vertreter: Feder Walter Ebert

(56) Entgegenhaltungen:
- EP-A1- 1 621 844
- WO-A1-2007/093912
- FR-A1- 2 885 854

## Beschreibung

Die Erfindung betrifft ein Fahrzeug, insbesondere Panzerfahrzeug, mit einer über eine Luke zugänglichen Wanne, deren Lukenöffnung mit einem über einen Antriebmechanismus bewegbaren Lukendeckel verschließbar ist, und einem ein Geschütz tragenden, gegenüber der Wanne drehbar angeordneten Turm, dessen Drehbewegungen mechanisch sperrbar sind. Einen weiteren Gegenstand der Erfindung bildet eine schließbare Fahrzeugöffnung mit einem über einen Antriebsmechanismus bewegbaren Schließelement zum Verschließen einer Öffnung.

In der militärischen Fahrzeugtechnik werden schließbare Fahrzeugöffnungen insbesondere als Luken an verschiedenen Stellen des Fahrzeugs vorgesehen, beispielsweise als Ein-/Ausstiegsluken.

Herkömmliche Panzerfahrzeuge setzen sich aus einer die Fahrzeugbesatzung und das Antriebsaggregat aufnehmenden Wanne und einem oberhalb der Wanne drehbar angeordneten, das Geschütz tragenden Turm zusammen. Das Innere der Wanne ist für die Besatzung über Ein-/Ausstiegsluken zugänglich.

Für den Kommandanten sowie für den Fahrer des Fahrzeugs ist oben an der Wanne eine Luke im Frontbereich des Fahrzeugs vorgesehen. Auch für andere Besatzungsmitglieder können Luken vorgesehen sein. Die Öffnungen an derartigen Luken erstrecken sich vom Inneren der Wanne nach fahrzeugaußen, so dass es z.B. dem Kommandanten möglich ist, in der Wanne des Kampffahrzeugs eine solche Sitzposition einzunehmen, in der ein Teil seines Körpers, insbesondere sein Kopf, aus der Lukenöffnung herausragt. Hierdurch ergeben sich für den Kommandanten verbesserte Sichtverhältnisse. Vor allem ist die Rundumsicht deutlich verbessert. Bei diesem auch als "Überluke-fahren" bezeichneten Fahrbetrieb besteht allerdings die Gefahr, dass der Kommandant durch Drehbewegungen des hinter oder neben seinem Kopf angeordneten Turms oder durch Schließbewegungen des Lukendeckels verletzt wird.

Um solchen Verletzungen vorzubeugen ist es bekannt, die Bewegungen des Lukendeckels sowie des Turms beim "Überlukefahren" zu blockieren und eine Schutzvorrichtung vorzusehen, die zunächst betätigt werden muss, bevor dann Drehbewegungen des Turms und/oder Schließbewegungen des Lukendeckels freigegeben werden.

In der EP 1 621 844 A1 wird als Schutzvorrichtung ein Rollo vorgeschlagen, das unterhalb Lukendeckels angeordnet und mit einem Endschalter zur Signalabgabe in der Schließstellung versehen ist. Erst wenn der Kommandant seinen Kopf aus der Öffnung, beispielsweise durch Absenken seines Sitzes, entfernt hat, kann das Rollo geschlossen und arretiert werden. Solange das Rollo nicht geschlossen und der Endschalter nicht betätigt ist, sind Drehbewegungen des Turms blockiert, er ist mechanisch gezurrt. Auch der Lukendeckel kann nicht in seine Schließstellung bewegt werden. Hierdurch wird vermieden, dass aus der Fahrzeugöffnung ragende Körperteile der Besatzung durch Drehbewegungen des Turms oder Schließbewegungen des Lukendeckels verletzt werden.

Diese Schutzmaßnahmen haben sich hinsichtlich ihrer Schutzwirkung für die Besatzung zwar durchaus bewährt, jedoch kann gerade in Kampfsituationen das vor dem Schließen der Luke und der Ausrichtung des Geschützes erforderliche Schließen des Rollos von Nachteil sein.

Das Schließen des Rollos und dessen Arretierung erfordert selbst für einen geübten Kommandanten eine Zeit von bis zu vier Sekunden, obwohl sich der Kommandant eigentlich schon außerhalb des unmittelbaren Gefahrenbereichs im Inneren der Wanne befindet.

**Aufgabe** der Erfindung ist es, ein Fahrzeug und eine schließbare Fahrzeugöffnung anzugeben, die sich durch eine geringe zeitliche Verzögerung zwischen dem Entfernen eines Körpers aus dem Gefahrenbereich und der Freigabe des Turms bzw. dem Schließen des Schließelements auszeichnen.

Diese Aufgabe wird bei einem Fahrzeug nach dem Anspruch 1 oder einer schließbaren Fahrzeugöffnung nach dem Anspruch 2 gelöst.

Mit Hilfe eines solchen Sensorelements wird die zeitliche Verzögerung zwischen dem Entfernen eines Körpers aus der Lukenöffnung und der Freigabe des Turms und/oder der Bewegung des Schließelements deutlich reduziert. Es ist nicht erforderlich, zunächst manuell ein Rollo zu betätigen. Unmittelbar nachdem der Körper, beispielsweise der Kopf oder ein Ausrüstungsgegenstand des Kommandanten, aus der Öffnung bzw. dem Gefahrenbereich zurückgezogen wurde, gibt das Sensorelement selbsttätig ein Signal ab, über welches der Antriebsmechanismus des Lukendeckels zum Schließen der Luke veranlasst und die mechanische Sperrung des Turms aufgehoben werden kann. Insgesamt wird eine Art Freigabeautomatik erreicht, welche gleichzeitig eine Schließbewegung des Lukendeckels und/oder die Freigabe des Turms initiiert. Das Fahrzeug wird mit geringer zeitlicher Verzögerung in einen Zustand der Kampfbereitschaft versetzt.

Bei einer schließbaren Fahrzeugöffnung der eingangs genannten Art wird die Aufgabe durch ein Sensorelement gelöst, das bei Entfernen eines Körpers aus der Öffnung ein Signal abgibt, über welches der Antriebsmechanismus zum Schließen der Öffnung veranlasst wird.

Mit Hilfe solcher Sensorelemente wird die zeitliche Verzögerung zwischen dem Entfernen eines Körpers aus der schließbaren Fahrzeugöffnung und der Freigabe des Schließelements deutlich reduziert. Es ist nicht erforderlich, zunächst manuell ein Rollo zu betätigen. Unmittelbar nachdem der Körper, beispielsweise der Kopf oder ein Ausrüstungsgegenstand des Kommandanten, aus der Öffnung zurückgezogen wurde, gibt das Sensorelement selbsttätig ein Signal ab, welches den Antriebsmechanismus des Schließelements zum Schließen der Fahrzeugöffnung veranlasst. Insgesamt wird eine Art Schließautomatik erreicht, welche mit geringer zeitlicher Verzögerung eine Schließbewegung Schließelements initiiert.

Gemäß einer Weiterbildung des Erfindungsgedankens wird vorgeschlagen, dass das Sensorelement an einer Innenfläche der Öffnung fahrzeugeinwärts des Lukendeckels angeordnet ist, wodurch sich eine kompakte, zuverlässig arbeitende Bauweise ergibt.

Von Vorteil für eine zuverlässige Signalabgabe des Sensorelements ist eine Ausgestaltung, bei der das Sensorelement die Form eines an den Querschnitt der Öffnung angepassten Rings aufweist. Das Sensorelement kann auch aus mehreren Ringsegmenten bestehen, wobei die Funktionalität jedes Segments, insbesondere auf Leitungsbruch, gesondert überwacht werden kann.

Gemäß einer weiteren Ausgestaltung wird vorgeschlagen, dass das Sensorelement ein kapazitiver Näherungssensor ist, was eine berührungslose Signalabgabe erlaubt.

Da die durch das Sensorelement erreichte Schließ- bzw. Freigabeautomatik nicht in allen Fahrsituationen gewünscht ist, wird weiter vorgeschlagen, dass eine Schaltvorrichtung vorgesehen ist, über welche sich die Signalübertragung vom Sensorelement zum Schließelement bzw. Lukendeckel unterbrechen lässt. In solchen Fahrsituationen, etwa bei Überführungsfahrten, kann der Kommandant seinen Kopf aus der Luke herausziehen, ohne dass diese sich selbsttätig schließt. Als Schaltvorrichtung kann beispielsweise ein im Inneren der Wanne angeordneter, elektrischer Schalter vorgesehen sein.

Weitere Einzelheiten und Vorteile des Kampffahrzeugs und der schließbaren Fahrzeugöffnung werden nachfolgend anhand eines in den Zeichnungen dargestellten Ausführungsbeispiels erläutert. Darin zeigen:
- Fig. 1: in seitlicher Ansicht eine zu Veranschaulichungszwecken ver- einfachte Darstellung eines Kampfpanzers,
- Fig. 2: eine vergrößerte Schnittdarstellung einer Luke des in Fig. 1 dargestellten Kampfpanzers,
- Fig. 3: in schematischer Draufsicht eine Einzelteilansicht der Luken- öffnung gemäß Fig. 2 und
- Fig. 4: in schematischer Darstellung eine vergrößerte Ansicht des Sensorelements zur Veranschaulichung von dessen Funkti- onsweise.

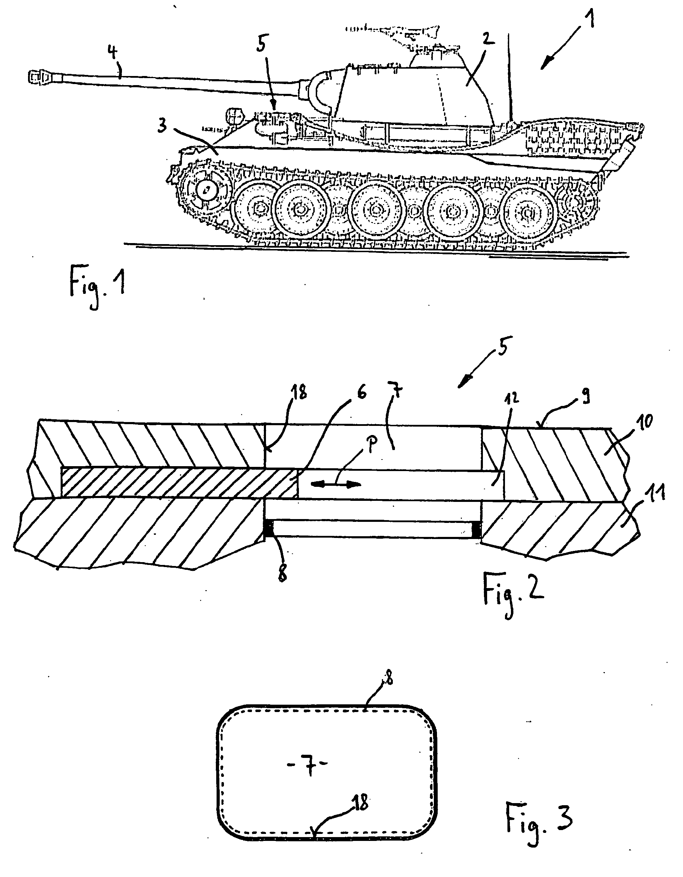

In Fig. 1 dargestellt ist in seitlicher Ansicht ein Panzerfahrzeug 1. Bei dem Panzerfahrzeug 1 handelt es sich um einen kettengetriebenen, aus einer gepanzerten Wanne 3 und einem das Geschütz 4 tragenden Turm 2 zusammengesetzten Kampfpanzer. Der Turm 2 und mit diesem das Geschütz 4 kann gegenüber der Wanne 3 gedreht und in Richtung eines Ziels ausgerichtet werden.

Im vorderen Bereich des Fahrzeugs 1 ist eine schließbare Fahrzeugöffnung in Form einer Luke 5 vorgesehen, die sich aus einem Lukendeckel 6 und einer Lukenöffnung 7 zusammensetzt und als Ein- und Ausstiegsluke und als sogenannte Kommandantenluke benutzt wird. Die Erfindung ist jedoch nicht auf solche Lukenöffnungen beschränkt, sondern lässt sich auch auf andere Arten von Fahrzeugöffnungen, etwa Heckklappen usw., übertragen.

Während der Fahrt kann der Kommandant seinen Sitz im Kampffahrzeug so verstellen, dass sein Kopf aus der Lukenöffnung 7 nach oben herausragt, wodurch sich die Rundumsicht des Kommandanten verbessert. Bei dem Kampffahrzeug 1 wird jedoch nicht immer "über Luke" gefahren. Insbesondere im Falle von Kampfeinsätzen ist es erforderlich, dass die Öffnung 7 geschlossen wird, so dass keine gegnerischen Kampfstoffe durch die Lukenöffnung 7 in das Innere der Wanne 3 eindringen können und die Besatzung im Inneren der Wanne 3 vor äußeren Zugriffen geschützt ist.

Wie die Darstellung in Fig. 2 zeigt, ist die Lukenöffnung 7 zu diesem Zweck über einen als Schließelement dienenden, gepanzerten Lukendeckel 6 verschließbar, der in Richtung des in Fig. 2 dargestellten Pfeils P hin und her bewegbar ist. Bei der dargestellten Luke 5 handelt es sich um eine sogenannte Schiebeluke. Nach Verschieben des Lukendeckels 6 in die Schließstellung ist die Lukenöffnung 7 und mit dieser die Wanne 3 nach fahrzeugaußen hin gas- und wasserdicht abgeschlossen. Zum Schutz vor feindlichen Sprengkörpern ist der Lukendeckel 6 gepanzert ausgeführt, weshalb er ein erhebliches Gewicht aufweist. Zum Bewegen des Lukendeckels 6 ist ein in den Figuren nicht dargestellter Antriebsmechanismus vorgesehen, der hydraulisch, pneumatisch und insbesondere elektromotorisch betätigbar sein kann.

Wie die Darstellung in Fig. 2 weiter erkennen lässt, ist die Bordwand des Fahrzeugs 1 im Bereich der Luke 5 zweiteilig, bestehend aus einer Außenplatte 10 und einer weiter innen liegenden Platte 11, ausgeführt, zwischen denen der Schiebedeckel 6 verschiebbar innerhalb eines Schachts aufgenommen ist. In Figur 2 dargestellt ist die Öffnungsstellung der Luke 5, in der der Lukendeckel 6 in eine garagenartige Öffnung zurückgezogen ist.

Die Lukenöffnung 7 weist beim Ausführungsbeispiel die Form eines eckgerundeten Rechtecks auf, wobei für einen ABC-dichten und sprengfesten Verschluss des Fahrzeuginnenraums eine umlaufende Ringnut 12 vorgesehen ist, in die der Lukendeckel 6 von der Seite her eindringen kann. In der Schließstellung stützt sich der Lukendeckel 6 über die Ringnut 12 nach fahrzeuginnen ab.

Wie die Darstellung in Fig. 1 erahnen lässt, ist es für den Kommandanten des Fahrzeugs 1 mit einem gewissen Risiko verbunden, wenn dieser seinen Kopf durch die Öffnung 7 nach fahrzeugaußen hindurch steckt und gleichzeitig der Turm 2 und mit diesem das Geschütz 4 gedreht wird. Abhängig vom Elevationswinkel des Geschützes 4, d.h. dem zwischen der Horizontalen und dem Geschütz 4 eingeschlossenen Winkel, kann es dabei zu lebensbedrohlichen Verletzungen des Kommandanten durch das Geschütz 4 kommen. Auch können solche Verletzungen von dem Turm 2 selbst herrühren, insbesondere wenn sich der Turm 2 auch seitlich der Luke 5 erstreckt. Ein weiteres Verletzungsrisiko ergibt sich für den Kommandanten durch unbeabsichtigtes oder verfrühtes Schließen des massiven Lukendeckels 6, über den die in die Lukenöffnung 7 ragende Körperteile des Kommandanten ebenfalls gequetscht oder abgeschert werden können.

Um solchen Verletzungen vorzubeugen ist vorgesehen, dass Drehbewegungen des Turms 2 und/oder Schließbewegungen des Deckels 6 nur dann möglich sind, wenn sich keine Körper, etwa Ausrüstungsgegenstände oder Körperteile der Besatzung, in der Lukenöffnung 7 befinden. Solange sich etwas in der Lukenöffnung 7 befindet, können weder der Lukendeckel 6 noch der der Turm 2 bewegt werden.

Das Entfernen eines Körpers aus der Öffnung 5 wird von einem Sensorelement 7, welches unterhalb des als Schiebeluke gestalteten Lukendeckels 6 innerhalb der Öffnung 7 angeordnet ist, unverzüglich erkannt und ein elektrisch nutzbares Signal abgegeben.

Sobald der Kommandant seinen Kopf oder einen in die Lukenöffnung 7 ragenden Ausrüstungsgegenstand, aus dem sensitiven Bereich des Sensorelements 8 entfernt hat, gibt das Sensorelement 8 ein Signal ab. Bei diesem Signal kann es sich um ein Schließsignal handeln, über welches der Antriebsmechanismus des Lukendeckels 6 automatisch zum Schließen der Lukenöffnung 7 veranlasst wird. Alternativ oder zusätzlich kann es sich bei dem Signal auch um ein Freigabesignal handeln, welches die mechanische Zurrung des Turms 2 aufhebt, wonach das Geschütz 4 in eine gewünschte Ausrichtung zu einem feindlichen Ziel gebracht werden kann.

Die Signalabgabe erfolgt unmittelbar nachdem der entsprechende Körper, dies kann auch etwa ein Arm, eine Hand oder ein sonstiger Gegenstand sein, aus der Lukenöffnung 7 entfernt wurde, wodurch sich eine geringe zeitliche Verzögerung zwischen dem Entfernen des Körpers und dem Schließen Lukendeckels 6 und/oder der Freigabe des Turms 2 ergibt. Vorteilhaft wird durch die Signalabgabe gleichzeitig der Schließvorgang der Luke 5 eingeleitet und die Sperrung des Turms 2 aufgehoben, so dass das Fahrzeug 1 ohne zeitliche Verzögerung in einen Zustand der Kampfbereitschaft überführt wird.

Aus Gründen des Einklemmschutzes ist zudem vorgesehen, dass ein während des Schließvorgangs in den sensitiven Bereich des Sensorelements 8 gebrachter Gegenstand den Schließvorgang unterbricht. Auch kann vorgesehen sein, dass hierdurch der Turm 2 erneut gezurrt wird. Auch ist vorgesehen, dass die Schließautomatik in bestimmten Fahrsituationen, etwa bei längeren Überführungsfahrten, über eine Schaltvorrichtung abschaltbar ist.

Wie die Figuren 2 und 3 zeigen, ist das berührungslos arbeitende Sensorelement 8 von insgesamt ringförmiger, an den Querschnitt der Lukenöffnung 7 angepasster Gestalt. Das Sensorelement 8 ist umlaufend an einer Innenfläche 18 der Lukenöffnung 7 angeordnet, wodurch sich eine zuverlässige Erkennung von Gegenständen in allen Bereichen der Lukenöffnung 7 ergibt. Der sensitive Bereich des Sensorelements 8, in dem das Vorhandensein bzw. Nichtvorhandensein von Körpern erfassbar ist, erstreckt sich über die gesamte Fläche der Lukenöffnung 7.

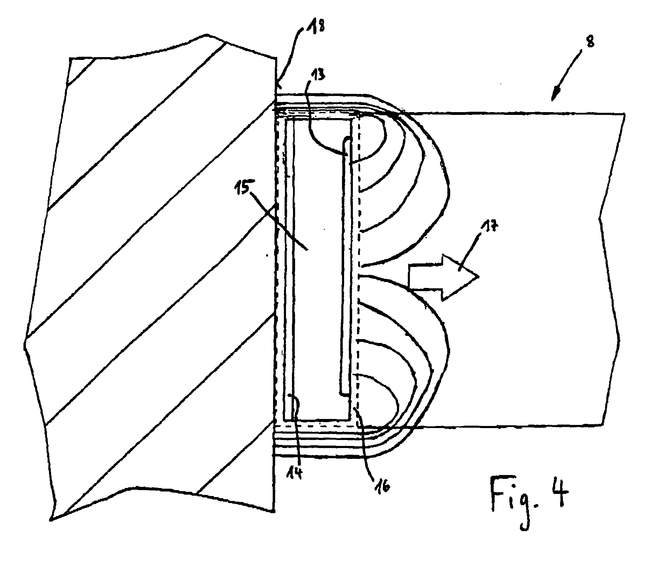

Einzelheiten des beim Ausführungsbeispiel als kapazitiver Sensor ausgestalteten Sensorelements 8 lassen sich der Darstellung in Figur 4 entnehmen. Das Sensorelement 8 ist von ringförmiger Gestalt und verläuft einmal um die Innenfläche 18 der Lukenöffnung 7 herum. Zu erkennen ist der Aufbau des-Sensorelements 8 aus zwei zueinander beabstandeten Elektroden 13 und 14, zwischen denen ein elektrischer Isolator 15 angeordnet ist. Bei der Elektrode 14 handelt es sich um eine in einem gewissen Abstand gegenüber der Innenfläche 18 montierte Schirmelektrode, die dafür sorgt, dass die Feldlinien des Feldes 17 den eingezeichneten Verlauf in Richtung des Zentrums der Lukenöffnung 7 nehmen. Das Feld 17 ist durch elektrische Feldlinien und einen Pfeil schematisiert eingezeichnet. Die Feldlinien erstrecken sich von der Elektrode 13 zunächst in Richtung des Zentrums der Öffnung 15 und enden an der Innenfläche 18.

Wenn sich kein Körper innerhalb der Lukenöffnung 7 befindet, haben die Feldlinien den in Figur 4 eingezeichneten, gleichmäßigen Verlauf. Solange sich aber ein Körper in der Lukenöffnung 7 befindet, wird hierdurch das Feld 17 beeinflusst, wodurch das Vorhandensein und auch das Nichtvorhandensein eines Körpers in der Lukenöffnung 7 detektierbar ist. Der Einfluss des Lukendeckels 6 auf das elektrische Feld 17 lässt sich dabei durch geeignete Maßnahmen minimieren.

Das Sensorelement 8 ist mit einem Abdeckmaterial, beispielsweise aus Gummi, versehen, das die Elektroden 13, 14 nach Art einer wasser- und sichtdichten Schutzhaut 16 umgibt, die dem Sensor 8 gleichzeitig auch ein einheitliches Aussehen verleiht und ggf. so ausgebildet ist, dass sie in der Lage ist, das elektrische Feld zu formen.

Das beschriebene Fahrzeug 1 und die schließbare Fahrzeugöffnung 5 zeichnen sich durch eine geringe zeitliche Verzögerung zwischen dem Entschluss des Kommandanten in das Innere des Fahrzeugs abzutauchen und der Kampfbereitschaft des Fahrzeugs aus. Verletzungsrisiken werden gemindert.

Bereits im Einsatz befindliche Fahrzeuge 1 bzw. deren Fahrzeugöffnungen 5 können mit Sensorelementen 8 und der zugehörigen Elektronik mit wenig Aufwand nachgerüstet werden.

### Bezugszeichen:

- 1: Fahrzeug
- 2: Turm
- 3: Wanne
- 4: Geschütz
- 5: schließbare Fahrzeugöffnung, Luke
- 6: Schließelement, Lukendeckel
- 7: Öffnung, Lukenöffnung
- 8: Sensorelement
- 9: Fahrzeugaußenfläche
- 10: Außenplatte
- 11: Innenplatte
- 12: Nut
- 13: Elektrode
- 14: Elektrode
- 15: Isolator
- 16: Abdeckmaterial
- 17: Feld
- 18: Innenfläche

- P: Pfeil, Bewegungsrichtung

## Patentansprüche

1. Fahrzeug, insbesondere Panzerfahrzeug, mit einer über eine Luke (5) zugänglichen Wanne (3), deren Lukenöffnung (7) mit einem über einen Antriebmechanismus bewegbaren Lukendeckel (6) verschließbar ist, und einem ein Geschütz (4) tragenden, gegenüber der Wanne (3) drehbar angeordneten Turm (2), dessen Drehbewegungen mechanisch sperrbar sind,
**gekennzeichnet durch**
ein Sensorelement (8), das bei Entfernen eines Körpers aus der Lukenöffnung (7) ein Signal abgibt, über welches der Antriebsmechanismus zum Schließen der Lukenöffnung (7) veranlasst und/oder eine mechanische Sperrung des Turms (2) aufgehoben wird.

2. Schließbare Fahrzeugöffnung mit einem über einen Antriebsmechanismus bewegbaren Schließelement (6) zum Verschließen einer Öffnung (7),
**gekennzeichnet durch**
ein Sensorelement (8), das bei Entfernen eines Körpers aus der Öffnung (7) ein Signal abgibt, über welches der Antriebsmechanismus zum Schließen der Öffnung (7) veranlasst wird.

3. Fahrzeugöffnung nach Anspruch 2, **dadurch gekennzeichnet, dass** das Schließelement (6) ein Lukendeckel und die Öffnung (7) eine Lukenöffnung ist.

4. Fahrzeug oder Fahrzeugöffnung nach einem der Ansprüche 1 bis 3, **dadurch gekennzeichnet, dass** das Sensorelement (8) an einer Innenfläche (18) der Öffnung (7) fahrzeugeinwärts des Schließelements (6) angeordnet ist.

5. Fahrzeug oder Fahrzeugöffnung nach einem der vorhergehenden Ansprüche, **dadurch gekennzeichnet, dass** das Sensorelement (8) die Form eines an den Querschnitt der Öffnung (7) angepassten Rings aufweist.

6. Fahrzeug oder Fahrzeugöffnung nach einem der Ansprüche 1 bis 5, **dadurch gekennzeichnet, dass** das Sensorelement (8) ein kapazitiver Näherungssensor ist.

7. Fahrzeug oder Fahrzeugöffnung nach einem der Ansprüche 1, 3 oder 4-6 in Kombination mit 3, **gekennzeichnet durch** eine Schaltvorrichtung, über welche sich die Signalübertragung vom Sensorelement (8) zum Lukendeckel (6) unterbrechen lässt.

## Claims

1. Vehicle, especially an armoured vehicle, comprising a hull (3), which is accessible through a hatch (5), the opening (7) of which can be closed by means of a hatch cover (6), which can be moved by means of a drive mechanism, and a turret (2), which is carrying a gun (4) and which is rotatable in relation to the hull (3), the rotating movements of which can be mechanically blocked, **characterised by** a sensor element (8), which, when a body is removed from the hatch opening (7), transmits a signal activating the drive mechanism in order to close the hatch opening (7) and/or causing a mechanical blocking of the turret (2) to be released.

2. Closable vehicle opening comprising a closing element (6) for closing an opening (7) that can be moved by a drive mechanism, **characterised by** a sensor element (8), which, when a body is removed through the opening (7), transmits a signal, by means of which the drive mechanism is activated so as to close the opening (7)

3. Vehicle opening according to Claim 2, **characterised in that** the closing element (6) is a hatch cover and the opening (7) is a hatch opening.

4. Vehicle or vehicle opening according to any of the above Claims 1 to 3, **characterised in that** the sensor (8) is positioned on the inner surface (18) of the opening (7) in the direction of the vehicle interior of the closing element (6).

5. Vehicle or vehicle opening according to any of the above Claims, **characterised in that** the sensor element (8) is in the form of a ring that fits into the cross-section of the opening (7).

6. Vehicle or vehicle opening according to any of the above Claims 1 to 5, **characterised in that** the sensor element (8) is a capacitive proximity sensor.

7. Vehicle or vehicle opening according to any of the above Claims 1 to 3, or 4 to 6 in combination with 3, **characterised by** a switching device, by means of which the signal being transmitted by the sensor element (8) to the hatch cover (6) can be interrupted.

## Revendications

1. Véhicule, plus particulièrement véhicule blindé, avec une caisse (3) accessible par l'intermédiaire d'une écoutille (5), dont l'ouverture d'écoutille (7) peut être verrouillée par l'intermédiaire d'un couvercle d'écoutille (6) mobile à l'aide d'un mécanisme d'entraînement, et une tourelle (2) disposée de manière rotative par rapport à la caisse (3), et supportant un canon (4), dont les mouvements de rotation peuvent être bloqués mécaniquement, **caractérisé par** un élément capteur (8), qui, lors du retrait d'un corps hors de l'ouverture d'écoutille (7), envoie un signal grâce auquel le mécanisme d'entraînement provoque la fermeture de l'ouverture d'écoutille (7) et/ou supprime un blocage mécanique de la tourelle (2).

2. Ouverture de véhicule verouillable avec un élément de fermeture (6) mobile grâce à un mécanisme d'entraînement pour le verrouillage d'une ouverture (7), **caractérisé par** un élément capteur (8), qui envoie un signal lors du retrait d'un corps hors de l'ouverture (7), grâce auquel le mécanisme d'entraînement provoque la fermeture de l'ouverture (7).

3. Ouverture de véhicule selon la revendication 2, **caractérisé en ce que** l'élément de fermeture (6) est un couvercle d'écoutille et l'ouverture (7) est une ouverture d'écoutille.

4. Véhicule ou ouverture de véhicule selon l'une des revendications 1 à 3, **caractérisé en ce que** l'élément capteur (8) est disposé sur la surface interne (18) de l'ouverture (7), vers l'intérieur de l'élément de fermeture (6).

5. Véhicule ou ouverture de véhicule selon l'une des revendications précédentes, **caractérisé en ce que** l'élément capteur (8) présente la forme d'une bague adaptée à la section de l'ouverture (7).

6. Véhicule ou ouverture de véhicule selon l'une des revendications 1 à 5, **caractérisé en ce que** l'élément capteur (8) est un capteur de proximité capacitif.

7. Véhicule ou ouverture de véhicule selon l'une des revendications 1, 3 ou 4 à 6 en combinaison avec la revendication 3, **caractérisé par** un dispositif de commutation permettant d'interrompre la transmission du signal de l'élément capteur (8) vers le couvercle d'écoutille (6).
